(19) **Europäisches Patentamt European Patent Office Office européen des brevets**

(11) **EP 4 007 174 B1**

(12) **EUROPEAN PATENT SPECIFICATION**

(45) Date of publication and mention
of the grant of the patent:
**15.11.2023 Bulletin 2023/46**

(21) Application number: **20851745.8**

(22) Date of filing: **24.07.2020**

(51) International Patent Classification (IPC):
*H03M 13/11* (2006.01)    *H03M 13/03* (2006.01)

(52) Cooperative Patent Classification (CPC):
**H03M 13/036; H03M 13/116; H03M 13/1177**

(86) International application number:
**PCT/CN2020/103929**

(87) International publication number:
**WO 2021/027525 (18.02.2021 Gazette 2021/07)**

(54) **METHOD FOR CONSTRUCTING REGULAR QC-LDPC CODE AND ELECTRONIC DEVICE**

VERFAHREN ZUR HERSTELLUNG EINES REGULÄREN QC-LDPC-CODES UND
ELEKTRONISCHE VORRICHTUNG

PROCÉDÉ POUR CONSTRUIRE UN CODE QC-LDPC CLASSIQUE ET DISPOSITIF
ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.08.2019 CN 201910744688**

(43) Date of publication of application:
**01.06.2022 Bulletin 2022/22**

(73) Proprietor: **ZTE Corporation**
**Shenzhen, Guangdong 518057 (CN)**

(72) Inventor: **TAO, Kai**
**Shenzhen, Guangdong 518057 (CN)**

(74) Representative: **Swindell & Pearson Limited**
**48 Friar Gate**
**Derby DE1 1GY (GB)**

(56) References cited:
**WO-A1-2017/105270     CN-A- 102 315 899
CN-A- 109 756 232**

• **MOHAMMAD H TADAYON ET AL: "Efficient
Search of Compact QC-LDPC and SC-LDPC
Convolutional Codes with Large Girth",
ARXIV.ORG, CORNELL UNIVERSITY LIBRARY,
201 OLIN LIBRARY CORNELL UNIVERSITY
ITHACA, NY 14853, 17 April 2018 (2018-04-17),
XP080871839,**

• **ZHANG LIJUN ET AL: "Constructions of QC LDPC
codes based on integer sequences", SCIENCE
CHINA INFORMATION SCIENCES, SCIENCE
CHINA PRESS, BEIJING, vol. 57, no. 6, 13 May
2014 (2014-05-13), pages 1-14, XP035317542,
ISSN: 1674-733X, DOI:
10.1007/S11432-013-4971-X [retrieved on
2014-05-13]**

• **IVAN B DJORDJEVIC ET AL: "Next Generation
FEC for High-Capacity Communication in Optical
Transport Networks", JOURNAL OF LIGHTWAVE
TECHNOLOGY, IEEE, USA, vol. PP, no. 16, 15
August 2009 (2009-08-15), pages 3518-3530,
XP011256666, ISSN: 0733-8724**

• **BATTAGLIONI MASSIMO ET AL: "Compact
QC-LDPC Block and SC-LDPC Convolutional
Codes for Low-Latency Communications",
PROC., IEEE 29TH ANNUAL INTERNATIONAL
SYMPOSIUM ON PERSONAL, INDOOR AND
MOBILE RADIO COMMUNICATIONS (PIMRC), 9
September 2018 (2018-09-09), pages 1-5,
XP033479401, DOI: 10.1109/PIMRC.2018.8580758
[retrieved on 2018-12-18]**

EP 4 007 174 B1

- TASDIGHI ALIREZA ET AL: "Symmetrical Constructions for Regular Girth-8 QC-LDPC Codes", IEEE TRANSACTIONS ON COMMUNICATIONS, vol. 65, 13 October 2016 (2016-10-13), pages 1-1, XP055947865, PISCATAWAY, NJ. USA. ISSN: 0090-6778, DOI: 10.1109/TCOMM.2016.2617335 Retrieved from the Internet: URL:https://ieeexplore.ieee.org/stampPDF/getPDF.jsp?tp=&arnumber=7590040&ref=aHR0cHM 6Ly9pZWVleHBsb3JlLmllZWUub3JnL2RvY3VtZW50L zc1OTAwNDA=> [retrieved on 2022-08-01]
- Zhiyu Feng, Haiying Peng, Zhenyong Guo, Rong Hu: "Construction of Large Girth QC-LDPC Codes for Fast Encoding", Journal of Chongqing University of Posts and Telecommunications(Natural Science Edition), vol. 30, no. 4, 15 August 2018 (2018-08-15), pages 498-504, XP055781249, ISSN: 1673-825X, DOI: 10.3979/j.issn.1673-825X.2018.04.010
- Zhang Guohua; Sun Rong; Wang Xinmei: "Several Explicit Constructions for(3, L) QC-LDPC Codes with Girth at Least Eight", IEEE Communications Letters, vol. 17, no. 9, 1 September 2013 (2013-09-01), pages 1822-1825, XP011527522, ISSN: 1089-7798, DOI: 10.1109/LCOMM.2013.070913.130966

## Description

## TECHNICAL FIELD

Embodiments of the present disclosure relate to the communications field, and in particular, relate to a method for constructing a regular QC-LDPC code and an electronic device, and a computer-readable storage medium.

## BACKGROUND

Quasi-Cyclic Low-Density Parity-Check (QC-LDPC) code is widely studied and applied as a representative to LDPC codes. The QC-LDPC code is a combination of a QC code and an LDPC code, and is characterized in remarkable error correction performance of the LDPC code and structural properties of the QC code.

Among various QC-LDPC code types, a common type is a QC-LDPC code based on a form of "Circulant Permutation Matrix (CPM)". A length of the shortest cycle in a Tanner graph corresponding to the check matrix of the QC-LDPC code is defined as a girth. A maximal girth of the check matrix is important in order to obtain good decoding performance.

MOHAMMAD H TADAYON ET AL.: "Efficient Search of Compact QC-LDPC and SC-LDPC Convolutional Codes with Large Girth", ARXIV.ORG, CORNELL UNIVERSITY LIBRARY, 201 OLIN LIBRARY CORNELL UNIVERSITY ITHACA, NY 14853, (20180417), proposes a low-complexity method to find quasi-cyclic low-density parity-check block codes with girth 10 or 12 and shorter length than those designed through classical approaches. The method is extended to time-invariant spatially coupled low-density parity-check convolutional codes, permitting to achieve small syndrome former constraint lengths.

ZHANG LIJUN ET AL.: "Constructions of QC LDPC codes based on integer sequences", SCIENCE CHINA INFORMATION SCIENCES, SCIENCE CHINA PRESS, BEIJING, vol. 57, no. 6, (20140513), proposes that three types of (2, F) and (3, F) quasi cyclic (QC) low-density parity-check (LDPC) codes are constructed based on difference sequence and Hoey sequence. All 4-cycles and even 6-cycles are removed in the Tanner graph, and the girth is not less than six. The decoding complexity as well as extension to irregular case is analyzed. Simulation results show that in AWGN and Rayleigh fading channels, the codes can achieve the same error performance as their counterpart PEG codes, and outperform the corresponding MacKay codes and array codes.

IVAN B DJORDJEVIC ET AL.: "Next Generation FEC for High-Capacity Communication in Optical Transport Networks", JOURNAL OF LIGHTWAVE TECHNOLOGY, IEEE, USA, vol. PP, no. 16, pages 3518 - 3530, (20090815), describes codes on graphs of interest for next generation forward error correction (FEC) in high-speed optical networks, namely turbo codes and low-density parity-check (LDPC) codes. This paper describes both binary and nonbinary LDPC codes, their design, and decoding. This paper also discusses an FPGA implementation of decoders for binary LDPC codes. This paper then explains how to combine multilevel modulation and channel coding optimally by using coded modulation. Also, this paper describes an LDPC-coded turbo-equalizer as a candidate for dealing simultaneously with fiber nonlinearities, PMD, and residual chromatic dispersion.

BATTAGLIONI MASSIMO ET AL.: "Compact QC-LDPC Block and SC-LDPC Convolutional Codes for Low-Latency Communications", PROC., IEEE 29TH ANNUAL INTERNATIONAL SYMPOSIUM ON PERSONAL, INDOOR AND MOBILE RADIO COMMUNICATIONS (PIMRC), (20180909), shows how certain requirements can be fulfilled by using some special quasi-cyclic low-density parity-check block codes and spatially coupled low-density parity-check convolutional codes that are denoted as compact. They are defined by parity-check matrices designed according to a recent approach based on sequentially multiplied columns. This method allows obtaining codes with girth up to 12.

TASDIGHI ALIREZA ET AL.: "Symmetrical Constructions for Regular Girth-8 QC-LDPC Codes", IEEE TRANSACTIONS ON COMMUNICATIONS, PISCATAWAY, NJ. USA., vol. 65, (20161013), proposes new constructions for regular girth-8 quasi-cyclic low-density parity-check (QC-LDPC) codes based on circulant permutation matrices (CPM). The constructions assume symmetries in the structure of the parity-check matrix and employ a greedy exhaustive search algorithm to find the permutation shifts of the CPMs. As a result of symmetries, the new codes have a more compact representation compared with their counterparts. In majority of cases, also, they achieve the girth 8 at a shorter block length for the same degree distribution (code rate). Deterministic (explicit) constructions are also presented to expand the proposed parity-check matrices to larger block lengths and higher rates. The proposed long high-rate codes are often substantially shorter than regular girth-8 QC-LDPC codes of similar rate in the literature. Simulation results demonstrate that the proposed symmetric codes have competitive performance in comparison with similar existing QC-LDPC codes that lack symmetry.

## SUMMARY

The embodiments of the present disclosure provide a method for constructing a regular QC-LDPC code and an electronic device, and a computer-readable storage medium.

An embodiment of the present disclosure provides a method for constructing a regular QC-LDPC code, including: initializing each element of a first row and a first column in a cyclic shift value matrix of a regular QC-LDPC code to 0; obtaining K values satisfying a preset condition, where a value of K is equal to a number of columns of the cyclic shift value matrix, and the preset condition includes that one of the K values is 0, and no duplicate number exists in a set consisting of differences each between any two of the K values; assigning the K values to K elements of a second row in the cyclic shift value matrix, respectively, where a first element of the second row is assigned a value of 0; searching, based on dimension quantity information of a circulant permutation matrix of the regular QC-LDPC code, for a value satisfying a preset girth condition for each element to be assigned a value, to obtain the cyclic shift value matrix, where each element to be assigned a value refers to an element other than elements of the first row, the second row, and the first column in the cyclic shift value matrix; constructing a check matrix of the regular QC-LDPC code based on the cyclic shift value matrix; and using the constructed regular QC-LDPC code for error correction by processing data to be transmitted or processing received data.

An embodiment of the present disclosure further provides an electronic device, including: at least one processor; and a memory communicatively connected to the at least one processor, where the memory stores instructions executable by the at least one processor to enable the at least one processor to perform the method for constructing a regular QC-LDPC code.

An embodiment of the present disclosure further provides a computer-readable storage medium storing a computer program which, when executed by a processor, causes the processor to perform the method for constructing a regular QC-LDPC code.

## BRIEF DESCRIPTION OF DRAWINGS

One or more embodiments are illustrated with reference to corresponding figures in the accompanying drawings, and these illustrations do not constitute a limitation to the embodiments. Elements having same reference signs in the accompanying drawings represent similar elements. The figures in the accompanying drawings are not necessarily drawn to scale unless otherwise specified.

Fig. 1 is an expression of a check matrix of a QC-LDPC code based on a "circulant permutation matrix";

Fig. 2 is an expression of a cyclic shift value matrix of a QC-LDPC code based on a "circulant permutation matrix";

Fig. 3 is a flowchart of a method for constructing a regular QC-LDPC code according to embodiment one of the present disclosure;

Fig. 4 is a detailed flowchart of step 104 according to embodiment one of the present disclosure;

Fig. 5 is a flowchart of a method for constructing a regular QC-LDPC code according to embodiment two of the present disclosure;

Fig. 6. is a flowchart of a method for constructing a regular QC-LDPC code according to embodiment three of the present disclosure; and

Fig. 7 is a block diagram of an electronic device according to embodiment four of the present disclosure.

## DETAILED DESCRIPTION

In order to make the purposes, technical schemes and advantages of the embodiments of the present disclosure clear, the embodiments of the present disclosure will be described in detail with reference to the accompanying drawings. Those having ordinary skills in the art can understand that, in various embodiments of the present disclosure, many technical details have been set forth in order to enable readers to better understand the present disclosure. However, even without these technical details and various changes and modifications based on the following embodiments, the technical schemes of the present disclosure can be implemented. The following embodiments are respectively provided for convenience of description, and should not constitute any limitation on various implementations of the present disclosure. The embodiments can be combined with and referenced by each other without conflict.

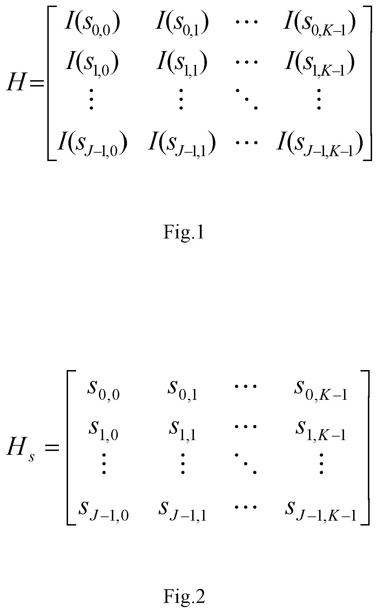

Among various QC-LDPC code types, a common type is a QC-LDPC code based on a form of "Circulant Permutation Matrix (CPM)", and a check matrix form $H$ of this type of QC-LDPC code is shown in Fig. 1. Each element $I(s_{i,j})$ represents a unit matrix or a cyclic shift matrix of a unit matrix, or an all-zero matrix. A cyclic shift value $s_{i,j}$ in the element $I(s_{i,j})$ is extracted to construct a cyclic shift value matrix $H_s$, thus transforming a design of a large-size check matrix $H$ into a smaller-size cyclic shift value matrix $H_s$. A form of the matrix $H_s$ is shown in Fig. 2. A QC-LDPC code in a form of all-zero sub-matrix does not exist in the check matrix, and is also referred to as a (J,K) regular QC-LDPC code, where J and K respectively refer to a column width and a row height of the check matrix $H$, that is, the number of rows and the number of columns of the cyclic shift value matrix $H_s$. A length of the shortest cycle in a Tanner graph corresponding to the check matrix of the QC-LDPC code is defined as a girth. A maximal girth of the check matrix is important in order to obtain good decoding performance.

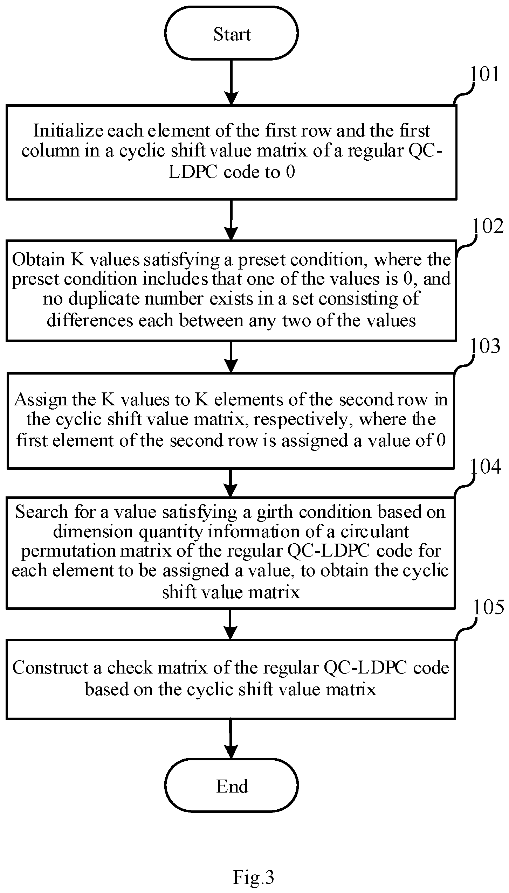

Embodiment one of the present disclosure relates to a method for constructing a regular QC-LDPC code. An illustrative process is shown in Fig. 3.

At step 101, each element of the first row and the first column in a cyclic shift value matrix of the regular QC-LDPC code is initialized to 0.

At step 102, K values satisfying a preset condition is obtained, where a value of K is equal to the number of columns of the cyclic shift value matrix, and the preset condition includes that one of the values is 0, and no duplicate number exists in a set consisting of differences each between any two of the values.

At step 103, K values are assigned to K elements of the second row in the cyclic shift value matrix, respectively, where the first element of the second row is assigned a value of 0.

At step 104, a value satisfying the girth condition is searched for based on dimension quantity information of a circulant permutation matrix of the regular QC-LDPC code for each element to be assigned a value, to obtain the cyclic shift value matrix, where each element to be assigned a value refers to an element other than elements of the first row, the second row, and the first column in the cyclic shift value matrix.

At step 105, a check matrix of the regular QC-LDPC code is constructed based on the cyclic shift value matrix.

The implementation details of the method for constructing a regular QC-LDPC code in this embodiment are described in detail below. The following contents are only provided for convenience of understanding, and should not be considered as necessities for the implementation of this scheme.

Construction of the regular QC-LDPC code is to construct the check matrix of the regular QC-LDPC code. Generally, values of the elements in the cyclic shift value matrix are determined based on the given number of rows, the number of columns, and a girth, to construct the check matrix according to the cyclic shift value matrix. In this embodiment and the following embodiments, the letters J, K, and G denote the number of rows, the number of columns, and the girth, respectively. To be specific, this embodiment provides a method for constructing a (J,K) regular QC-LDPC code with a girth g.

In this embodiment, specific values of the preset number of rows J, the number of columns K, and the girth G are not limited. In an example, the specified girth may be 8, 10 or 12. In other words, this embodiment can be used to search for a (J,K) regular QC-LDPC code with a large girth.

At step 101, according to the given number of rows J and the number of columns K, a cyclic shift value matrix $H_s$ with J rows and K columns is created, and each element in the cyclic shift value matrix $H_s$ is initialized. During initialization, all elements in the first row and first column of the cyclic shift value matrix $H_s$ are assigned a value of 0, and the rest of the elements can be assigned a default value that is of a to-be-assigned meaning in the system. For example, if a default value of -1 in the system means a value used for assignment, the remaining elements can be assigned the value of -1.

At step 102 and step 103, K values satisfying a preset condition are obtained, and these K values respectively correspond to K elements in the second row of the cyclic shift value matrix $H_s$. The K values need to satisfy the preset condition, that is: one of the values is 0, and no duplicate number exists in a set consisting of differences each between any two of the values.

For example, K=4, and the K values are a1, a2, a3 and a4, respectively. If a difference between a1 and a2 is recorded as b12, a difference between a1 and a3 as b13, a difference between a1 and a4 as b14, a difference between a2 and a3 as b23, a difference between a2 and a4 as b24, and a difference between a3 and a4 as b34, no duplicate number exists in the set {b12, b13, b14, b23, b24, b34}, that is, b12, b13, b14, b23, b24, b34 are different from each other. In addition, one of a1, a2, a3 and a4 is 0. During assigning values to the elements of the second row, the first element of the second row is assigned a value of 0, and the remaining three elements of the second row are assigned the other three values.

0 can be ranked in the first place of the K values, or the K values are ranked in ascending order. In this case, when assigning values to the elements of the second row, the K values can be assigned to the elements of the second row in the order of the K values.

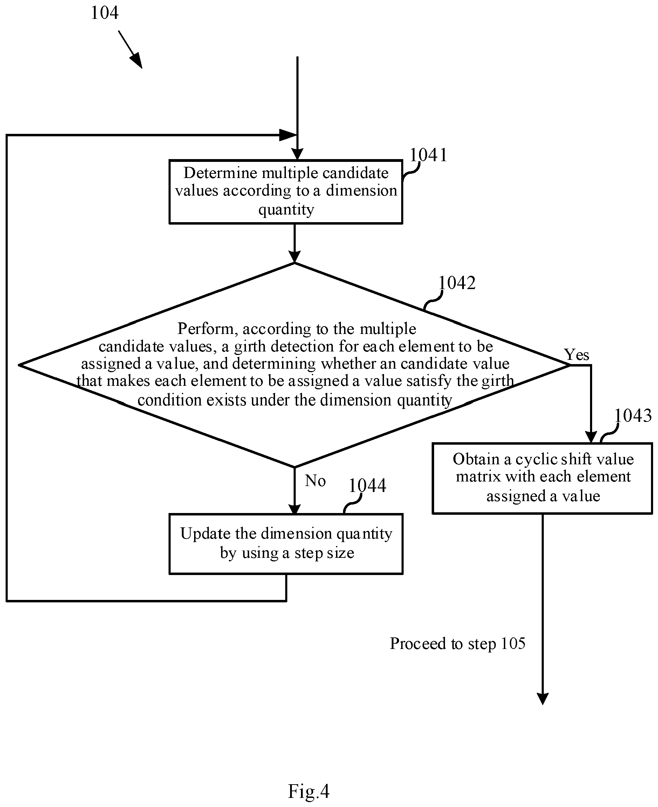

In an example, as shown in fig. 4, step 104 includes the following sub-steps.

At sub-step 1041, multiple candidate values are determined according to a dimension quantity.

At sub-step 1042, girth detection is performed according to the multiple candidate values for each element to be assigned a value, and whether a candidate value that makes each element to be assigned a value satisfy the girth condition exists under the dimension quantity is determined. If such candidate value exists, the process proceeds to sub-step 1043. If such candidate value does not exist, the process proceeds to sub-step 1044.

At sub-step 1043: The cyclic shift value matrix with each element assigned a value is obtained.

At sub-step 1044, the dimension quantity is updated by using a step size. Then step 104 is repeated.

In this embodiment, the dimension quantity information includes an initial value and the step size of the dimension quantity, where the initial value of the dimension quantity is an integer greater than 1. In this embodiment, the letters P and Step denote the dimension quantity and the step size, respectively. When step 104 is performed for the first time, the multiple candidate values are determined by using the initial value of the dimension quantity.

At sub-step 1041, the multiple candidate values determined according to the dimension quantity P are arranged in sequence as follows: 1, 2, ...P-1. In other words, an optional value set PM can be determined according to the dimension quantity P. The candidate value set includes several candidate values arranged in ascending order, and can be expressed as PM={1,2,3, ..., p-1}.

At sub-step 1042, girth detection may be performed sequentially for each element to be assigned a value according to the multiple candidate values from left to right and from top to bottom. In other words, the detection order is the second element of the third row, the third element of the third row, ..., and the $K^{th}$ element of the third row; the second element of the fourth row, the third element of the fourth row, ..., the $K^{th}$ element of the fourth row; ...; the second element of the $J^{th}$ row, the third element of the $J^{th}$ row, ..., and the $K^{th}$ element of the $J^{th}$ row.

Sub-step 1042 can be implemented as follows.

At step a, during girth detection for each element to be assigned a value, the candidate values are selected from the candidate value set PM sequentially. For each candidate value, only when it is determined that the candidate value does not exist in the cyclic shift value matrix, the candidate value can be assigned to the element to be assigned a value and girth detection is performed. In other words, for each candidate value, it is determined whether the candidate value exists in the cyclic shift value matrix. If the candidate value does not exist in the cyclic shift value matrix, the candidate value is assigned to the element to be assigned a value and girth detection is performed. If the candidate value already exists in the cyclic shift value matrix, the candidate value will not be assigned to the element to be assigned a value for girth detection.

Whether the candidate value exists in the cyclic shift value matrix means whether the candidate value is the same as a value of any element in the cyclic shift value matrix. If the candidate value is the same as a value of an element in the cyclic shift value matrix, it indicates that the candidate value already exists in the cyclic shift value matrix. If the candidate value is different from the value of any element, it indicates that the candidate value does not exist in the cyclic shift value matrix.

If the candidate value already exists in the cyclic shift value matrix, the girth condition cannot be satisfied when girth detection is performed for the element to be assigned a value by using the candidate value. Therefore, in this example, by determining whether the candidate value already exists in the cyclic shift value matrix, a candidate value that will inevitably lead to detection failure can be removed first, thus reducing search times and further improving a search speed. It should be noted that in another example, at sub-step 1042, the multiple candidate values may alternatively be assigned in sequence to the element to be assigned a value and then girth detection is performed.

Girth detection in this embodiment means determining whether a girth of the check matrix at a time when the element to be assigned a value is assigned the candidate value is greater than or equal to the preset girth G. If the girth is greater than or equal to the present girth G, it indicates that the candidate value can make the element to be assigned a value satisfy the girth condition, that is, the candidate value is an optional value of the element to be assigned a value. If the girth is less than the present girth G (that is, there is a ring of a length less than the girth G in the check matrix at this time), it indicates that the candidate value is not the optional value of the element to be assigned a value. Here, rings of various lengths less than G may be searched for. For example, if G is 10, rings with lengths of 4, 6 and 8 may be searched for to determine whether a ring of a length less than G exists. In this way, it can be ensured that no ring of a length less than G exists. In other words, it is ensured that the girth is greater than or equal to G.

There may be several candidate values in the multiple candidate values that can make the element to be assigned a value satisfy the girth condition, and any one of the several candidate values that can make the element to be assigned a value satisfy the girth condition can be assigned to the element to be assigned a value. In this embodiment, an optional value set Cand_$S_{i,j}$ is created for the element to be assigned a value in advance, where $S_{i,j}$ represents the element to be assigned a value, $2 \leq i \leq J-1$, $1 \leq j \leq K-1$, and both i and j are integers. The candidate value satisfying the girth condition is added into the optional value set Cand_$S_{i,j}$ corresponding to the element to be assigned a value until girth detection for the element to be assigned a value by using each candidate value is completed.

Then, the process proceeds to a value assignment step, which includes the following sub-steps b and c.

At step b, whether Cand_$S_{i,j}$ is an empty set is determined. If Cand_$S_{i,j}$ is a non-empty set, an optional value from Cand_$S_{i,j}$ is selected and assigned to the element $S_{i,j}$ to be assigned a value, and girth detection is performed for a next element to be assigned a value after the element $S_{i,j}$ to be assigned a value according to the above multiple candidate values, until detection for all the elements to be assigned a value is completed. If all the elements to be assigned a value are assigned values, it is determined that a candidate value that makes each element to be assigned a value satisfy the girth condition exists under the dimension quantity, and the process proceeds to sub-step 1043.

At step c, if Cand_$S_{i,j}$ is an empty set, it indicates that a current assigned value of a previous element of $S_{i,j}$ affects selection of an optional value of $S_{i,j}$, and in this case, the following operations are performed for the previous element of $S_{i,j}$: The current value of the previous element of $S_{i,j}$ needs to be removed from an optional value set of the previous element of $S_{i,j}$, the previous element of $S_{i,j}$ is reused as an element to be assigned a value, and the value assignment step is repeated, that is, step b is returned. If $S_{i,j}$ is the second element in the third row, then $S_{i,j}$ does not have a previous element. In this case, it is determined that no candidate value that makes each element to be assigned a value satisfy the girth condition exists under the dimension quantity. Then, the process proceeds to sub-step 1044, that is, using a sum of the dimension quantity and the step size as a new dimension quantity to update the dimension quantity. After the dimension quantity is updated, step 104 is returned.

To be specific, if no candidate value that makes each element to be assigned a value satisfy the girth condition exists under the current dimension quantity, then step 104 is repeated after updating the dimension quantity, to search under an updated dimension quantity. Provided that the candidate value that makes each element to be assigned a value satisfy the girth condition has not been found, step 104 is repeatedly executed until a value satisfying the girth condition for each element to be assigned a value is found. In this way, the cyclic shift value matrix of the regular QC-LDPC code with each element to be assigned a value having been assigned a value is obtained. At the same time, a dimension quantity of the circulant permutation matrix can be obtained, that is, the cyclic shift value matrix found under the dimension quantity.

At step 105, according to the found circulant shift value matrix and the dimension quantity of the circulant permutation matrix, that is, the found dimension quantity of the circulant permutation matrix on which the cyclic shift value matrix is based, a check matrix of a (J,K) regular QC-LDPC code of the girth G is constructed, that is, a (J,K) regular QC-LDPC code of the girth G is constructed.

In this embodiment, when the obtained K values satisfy the preset condition, and the K values are used to assign values to the elements of the second row, it can be ensured that the first row and the second row will not generate loops of lengths of 4 and 8; A ring of the length of 6 may not appear until the third row, and therefore the ring of the length of 6 may not be considered during assigning values to the elements of the second row. In the search of the elements to be assigned a value, a value of a loop of a length less than girth G in the check matrix may not be considered for use (that is, if the girth G is greater than 6, a loop of a length of 6 may not be considered for use).

Compared with the conventional technology, in this embodiment, the elements of the first row and the first column of the cyclic shift value matrix of the regular QC-LDPC code are initialized to 0. Then, multiple values satisfying the preset condition are obtained and assigned to the elements of the second row in the cyclic shift value matrix, respectively. The preset condition includes that one of the values is 0, and no duplicate number exists in a set consisting of differences each between any two of the values. In this case, it is possible to ensure that the first two rows of the matrix do not have rings of specific lengths, to first determine values of the elements of the second row. Then, a value of each element to be assigned a value is searched for based on the dimension quantity information of the circulant permutation matrix. Each element to be assigned a value refers to an element other than elements of the first row, the second row, and the first column in the cyclic shift value matrix. In other words, the elements to be assigned a value that need to be assigned a value through searching start from the second element of the third row rather than the second row. Compared with the conventional technology, the number of elements to be assigned a value that need to be assigned a value through searching is reduced, thus reducing a search time of the cyclic shift value matrix and improving a construction speed of the regular QC-LDPC code. Especially in a case of a high bit rate and a large girth, the search time can be greatly reduced, thereby greatly improving the construction speed of the regular QC-LDPC code.

Especially in the case of a high bit rate and a large girth, when a column width is fixed, as the bit rate increases, a size of the check matrix increases accordingly. Therefore, more cyclic shift values that satisfy the girth condition need to be searched for. When the bit rate is fixed, as the girth increases, the girth condition that needs to be met imposes higher requirements, and the search for each cyclic shift value becomes more complicated. Therefore, the present disclosure can greatly reduce the search time in the case of a high bit rate and a large girth.

The following is a practical example of constructing the (J,K) regular QC-LDPC code of the girth G according to the method of this embodiment. It should be noted that division of steps in the following practical example is merely another way for clear description. During implementation, the following steps can be combined into one step, or some steps can be divided into multiple steps, which include a same logical relationship as the steps in Fig. 3 and Fig. 4.

Example 1: Construct a (3,6) regular QC-LDPC code with a girth of 8.

At step 1, it is known according to input parameters that J is 3, K is 6, and the girth is 8. A 3*6 cyclic shift value matrix $H_s$ is created and initialized. The initialized $H_s$ is as follows:

$$H_s = \begin{bmatrix} 0 & 0 & 0 & 0 & 0 & 0 \\ 0 & -1 & -1 & -1 & -1 & -1 \\ 0 & -1 & -1 & -1 & -1 & -1 \end{bmatrix}$$

At step 2, according to the number of columns K of 6, multiple values {1,5,11,24,25,27} are selected from a difference set (31,6,1). The smallest value "1" is subtracted from the six values, and values {0,4,10,23,24,26} are obtained and used as elements of the second row of the cyclic shift value matrix. At this time, $H_s$ is as follows:

$$H_s = \begin{bmatrix} 0 & 0 & 0 & 0 & 0 & 0 \\ 0 & 4 & 10 & 23 & 24 & 26 \\ 0 & -1 & -1 & -1 & -1 & -1 \end{bmatrix}$$

It should be noted that the six values selected from the difference set (31,6,1) are not fixed but random. The above is merely an example.

At step 3, an initial value of the dimension quantity P of the circulant permutation matrix is 27, and the step size Step is 1. Elements of the third row of the cyclic shift value matrix $H_s$ are traversed and searched for as follows:

At step 3.1, according to the second row of elements in the cyclic shift value matrix $H_s$, used flags Choose_0, Choose_4, Choose_10, Choose_23, Choose_24, and Choose_26 of the used values 0, 4, 10, 23, 24, and 26 are set to true, and unused flags are set to false. An initial value of a search position i is set to 1 and a search return flag Return i is set to false.

At step 3.2, optional values that are of elements and that satisfy the girth condition are determined one by one from left to right starting from the second element $S_{2,i=1}$ of the third row, and these values are input into an optional value set Cand_$S_{2,i}$. The step is stopped until i equals to 6. A detailed work process includes the following steps:

At step 3.2.1, starting from i=1, whether the search return flag Return_i is true is first determined. If Return_i is false, it indicates that an optional value can be searched for the element $S_{2,i}$ and step 3.2.2 is performed. If Return_i is true, it indicates that no optional value satisfying the girth condition can be found for this element. In this case, a previous element $S_{2,i-1}$ needs to be returned for value re-assignment and searching, and step 3.2.4 is performed.

At step 3.2.2, the initial value of the dimension quantity P is 27, and a set {1,2,3, ..., 26} is determined according to the dimension quantity. Values in a set {1,2,3, ..., 26} are assigned to j one by one. If j has already existed in the matrix $H_s$, that is, Choose_j is true, the value is skipped and detection is directly performed on a next value. If Choose_j is false, j is assigned to $S_{2,i}$ and girth detection is performed. If a girth existing in the cyclic shift value matrix is not less than the specified girth of 8, that is, Judge_cycle is true, it indicates that j is an optional value, and the value is put into the optional value set Cand_$S_{2,i}$. Then detection is performed on a next value. If a ring of a length less than 8 exists in the matrix, it indicates that the value j is not optional, and detection is directly performed on a next value. After all the elements in the set {1, 2, 3, ..., 26} are traversed, the process proceeds to step 3.2.3.

At step 3.2.3, whether the current optional value set Cand_$S_{2,i}$ is an empty set is determined. If Cand_$S_{2,i}$ is a non-empty set, that is, a size(Cand_$S_{2,i}$) is not equal to 0, a random number is selected from the set Cand_$S_{2,i}$ and assigned to $S_{2,i}$, the used value flag Choose_$S_{2,i}$ is set to true, i is automatically increased by 1, and then step 3.2.1 is performed for optional value search for the next element $S_{2,i+1}$. If Cand_$S_{2,i}$ is an empty set, that is, size(Cand_$S_{2,i}$)=0, it indicates that a current assigned value of the previous element $S_{2,i-1}$ affects selection of an optional value of $S_{2,i}$, it is stipulated that the search return flag Return i is true, i is decreased by 1, and step 3.2.1 is performed.

At step 3.2.4, the used value flag Choose_$S_{2,i}$ of $S_{2,i}$ is set to false, and then whether the optional value set Cand_$S_{2,i}$ is an empty set is determined. If Cand_$S_{2,i}$ is a non-empty set, that is, the size(Cand_S2,i) is not equal to 0, a random number is selected from the set Cand_$S_{2,i}$ and assigned to the used value flag Choose_$S_{2,i}$, the used value flag Choose_$S_{2,i}$ is set to true, i is automatically increased by 1, and then step 3.2.1 is performed for optional value search for $S_{2,i+1}$. If Cand_$S_{2,i}$ is an empty set, that is, size(Cand_$S_{2,i}$)=0, whether the value of i is 1 at this time is determined. If i is equal to 1, it indicates that the cyclic shift value matrix that satisfies the conditions cannot be found under the current value of P. The current value of P is added to Step and a sum of P and Step is assigned to P again, and step 3.1 is performed to restart the search. If i is not equal to 1, it indicates that the value of the previous element $S_{2,i-2}$ affects values of $S_{2,i-1}$ and $S_{2,i}$. The search return flag Return_i is set to false, Return_(i-1) is set to true, i is decreased by 1, and step 3.2.1 is performed.

At step 3.3, when values of all elements of the third row of the cyclic shift value matrix $H_s$ are determined, it indicates that an appropriate cyclic shift value matrix has been found, and then traversal and search is directly jumped out.

At step 4, the cyclic shift value matrix $H_s$ obtained by traversal search and the current value pf P are output. The cyclic shift value matrix $H_s$ is as follows:

$$H_s = \begin{bmatrix} 0 & 0 & 0 & 0 & 0 & 0 \\ 0 & 4 & 10 & 23 & 24 & 26 \\ 0 & 2 & 20 & 11 & 5 & 17 \end{bmatrix}$$

The value of P is 27.

At step 5, the check matrix is obtained according to the cyclic shift value matrix $H_s$ and the value of P.

Example 2: Construct a (3,8) regular QC-LDPC code with a girth of 10.

At step 1, it is known according to input parameters that J is 3, K is 8, and the girth is 10. A 3*8 cyclic shift value matrix $H_s$ is created and initialized. The initialized $H_s$ is as follows:

$$H_s = \begin{bmatrix} 0 & 0 & 0 & 0 & 0 & 0 & 0 & 0 \\ 0 & -1 & -1 & -1 & -1 & -1 & -1 & -1 \\ 0 & -1 & -1 & -1 & -1 & -1 & -1 & -1 \end{bmatrix}$$

At step 2, according to the number of columns K of 8, multiple values {1,6,7,9,19,38,42,49} are selected from a difference set (57,8,1). The smallest value "1" is subtracted from the eight values, and values {0,5,6,8,18,37,41,48} are obtained and used as elements of the second row of the cyclic shift value matrix. At this time, $H_s$ is as follows:

$$H_s = \begin{bmatrix} 0 & 0 & 0 & 0 & 0 & 0 & 0 & 0 \\ 0 & 5 & 6 & 8 & 18 & 37 & 41 & 48 \\ 0 & -1 & -1 & -1 & -1 & -1 & -1 & -1 \end{bmatrix}$$

It should be noted that the eight values selected from the difference set (57,8,1) are not fixed but random. The above is merely an example.

At step 3, an initial value of the dimension quantity P of the circulant permutation matrix is 49, and the step size Step is 1. Elements of the third row of the cyclic shift value matrix $H_s$ are traversed and searched for as follows:

At step 3.1, according to the second row of elements in the cyclic shift value matrix $H_s$, used flags Choose_0, Choose_5, Choose_6, Choose_8, Choose_18, Choose_37, Choose_41, Choose_48 of the used values 0, 5, 6, 8, 18, 37, 41, and 48 are set to true, and unused flags are set to false. An initial value of a search position i is set to 1 and a search return flag Return_i is set to false.

At step 3.2, optional values that are of elements and that satisfy the girth condition are determined one by one from left to right starting from the second element $S_{2,i=1}$ of the third row, and these values are input into an optional value set Cand_$S_{2,i}$. The step is stopped until i equals to 8. A detailed work process includes the following steps:

At step 3.2.1, starting from i=1, whether the search return flag Return_i is true is first determined. If Return_i is false, it indicates that an optional value can be searched for the element $S_{2,i}$ and step 3.2.2 is performed. If Return_i is true, it indicates that no optional value satisfying the girth condition can be found for this element. In this case, a previous element $S_{2,i-1}$ needs to be returned for value re-assignment and searching, and step 3.2.4 is performed.

At step 3.2.2, the initial value of the dimension quantity P is 49, and a set {1,2,3, ..., 48} is determined according to the dimension quantity. Values in a set {1,2,3, ..., 48} are assigned to j one by one. If j has already existed in the matrix $H_s$, that is, Choose_j is true, the value is skipped and detection is directly performed on a next value. If Choose_j is false, j is assigned to $S_{2,i}$ and girth detection is performed. If a girth existing in the cyclic shift value matrix is not less than the specified girth of 10, that is, Judge_cycle is true, it indicates that j is an optional value, and the value is put into the optional value set Cand_$S_{2,i}$. Then detection is performed on a next value. If a ring of a length less than 10 exists in the matrix, it indicates that the value j is not optional, and detection is directly performed on a next value. After all the elements in the set {1, 2, 3, ..., 48} are traversed, the process proceeds to step 3.2.3.

At step 3.2.3, whether the current optional value set Cand_$S_{2,i}$ is an empty set is determined. If Cand_$S_{2,i}$ is a non-empty set, that is, a size(Cand_$S_{2,i}$) is not equal to 0, a random number is selected from the set Cand_$S_{2,i}$ and assigned to $S_{2,i}$, the used value flag Choose_$S_{2,i}$ is set to true, i is automatically increased by 1, and then step 3.2.1 is performed for optional value search for the next element $S_{2,i+1}$. If Cand_$S_{2,i}$ is an empty set, that is, size(Cand_$S_{2,i}$)=0, it indicates that a current assigned value of the previous element $S_{2,i-1}$ affects selection of an optional value of $S_{2,i}$, it is stipulated that the search return flag Return i is true, i is decreased by 1, and step 3.2.1 is performed.

At step 3.2.4, the used value flag Choose_$S_{2,i}$ of $S_{2,i}$ is set to false, and then whether the optional value set Cand_$S_{2,i}$ is an empty set is determined. If Cand_$S_{2,i}$ is a non-empty set, that is, the size(Cand_S2,i) is not equal to 0, a random number is selected from the set Cand_$S_{2,i}$ and assigned to the used value flag Choose_$S_{2,i}$, the used value flag Choose_$S_{2,i}$ is set to true, i is automatically increased by 1, and then step 3.2.1 is performed for optional value search for $S_{2,i+1}$. If Cand_$S_{2,i}$ is an empty set, that is, size(Cand_$S_{2,i}$)=0, whether the value of i is 1 at this time is determined. If i is equal to 1, it indicates that the cyclic shift value matrix that satisfies the conditions cannot be found under the current value of P. The current value of P is added to Step and a sum of P and Step is assigned to P again, and step 3.1 is performed to restart the search. If i is not equal to 1, it indicates that the value of the previous element $S_{2,i-2}$ affects values of $S_{2,i-1}$ and $S_{2,i}$. The search return flag Return_i is set to false, Return_(i-1) is set to true, i is decreased by 1, and step 3.2.1 is performed.

At step 3.3, when values of all elements of the third row of the cyclic shift value matrix $H_s$ are determined, it indicates that an appropriate cyclic shift value matrix has been found, and then traversal and search is directly jumped out.

At step 4, the cyclic shift value matrix $H_s$ obtained by traversal search and the current value pf P are output. The cyclic shift value matrix $H_s$ is as follows:

$$H_s = \begin{bmatrix} 0 & 0 & 0 & 0 & 0 & 0 & 0 & 0 \\ 0 & 5 & 6 & 8 & 18 & 37 & 41 & 48 \\ 0 & 67 & 229 & 95 & 139 & 207 & 285 & 119 \end{bmatrix}$$

The value of P is 299.

At step 5, the check matrix is obtained according to the cyclic shift value matrix $H_s$ and the value of P.

Example 3: Construct a (3,12) regular QC-LDPC code with a girth of 12.

At step 1, it is known according to input parameters that J is 3, K is 12, and the girth is 12. A 3*12 cyclic shift value matrix $H_s$ is created and initialized. The initialized $H_s$ is as follows:

$$H_s = \begin{bmatrix} 0 & 0 & 0 & 0 & 0 & 0 & 0 & 0 & 0 & 0 & 0 & 0 \\ 0 & -1 & -1 & -1 & -1 & -1 & -1 & -1 & -1 & -1 & -1 & -1 \\ 0 & -1 & -1 & -1 & -1 & -1 & -1 & -1 & -1 & -1 & -1 & -1 \end{bmatrix}$$

At step 2, according to the number of columns K of 12, multiple values {1,11,16,40,41,43,52,60,74,78,121,128} are selected from a difference set (133,12,1). The smallest value "1" is subtracted from the twelve values, and values {0,10,15,39,40,42,51,59,73,77,120,127} are obtained and used as elements of the second row of the cyclic shift value matrix. At this time, $H_s$ is as follows:

$$H_s = \begin{bmatrix} 0 & 0 & 0 & 0 & 0 & 0 & 0 & 0 & 0 & 0 & 0 & 0 \\ 0 & 10 & 15 & 39 & 40 & 42 & 51 & 59 & 73 & 77 & 120 & 127 \\ 0 & -1 & -1 & -1 & -1 & -1 & -1 & -1 & -1 & -1 & -1 & -1 \end{bmatrix}$$

It should be noted that the twelve values selected from the difference set (133,12,1) are not fixed but random. The above is merely an example.

At step 3, an initial value of the dimension quantity P of the circulant permutation matrix is 128, and the step size Step is 1. Elements of the third row of the cyclic shift value matrix $H_s$ are traversed and searched for as follows:

At step 3.1, according to the second row of elements in the cyclic shift value matrix $H_s$, used flags Choose_0, Choose_10, Choose_15, Choose_39, Choose_40, Choose_42, Choose_51, Choose_59, Choose_73, Choose_77, Choose_120, and Choose_127 of the used values 0, 10, 15, 39, 40, 42, 51, 59, 73, 77, 120 and 127 are set to true, and unused flags are set to false. An initial value of a search position i is set to 1 and a search return flag Return_i is set to false.

At step 3.2, optional values that are of elements and that satisfy the girth condition are determined one by one from left to right starting from the second element $S_{2,i=1}$ of the third row, and these values are input into an optional value set Cand_$S_{2,i}$. The step is stopped until i equals to 12. A detailed work process includes the following steps:

At step 3.2.1, starting from i=1, whether the search return flag Return_i is true is first determined. If Return_i is false, it indicates that an optional value can be searched for the element $S_{2,i}$ and step 3.2.2 is performed. If Return_i is true, it indicates that no optional value satisfying the girth condition can be found for this element. In this case, a previous element $S_{2,i-1}$ needs to be returned for value re-assignment and searching, and step 3.2.4 is performed.

At step 3.2.2, the initial value of the dimension quantity P is 128, and a set {1,2,3, ..., 127} is determined according to the dimension quantity. Values in a set {1,2,3, ..., 127} are assigned to j one by one. If j has already existed in the matrix $H_s$, that is, Choose_j is true, the value is skipped and detection is directly performed on a next value. If Choose_j is false, j is assigned to $S_{2,i}$ and girth detection is performed. If a girth existing in the cyclic shift value matrix is not less than the specified girth of 12, that is, Judge_cycle is true, it indicates that j is an optional value, and the value is put into the optional value set Cand_$S_{2,i}$. Then detection is performed on a next value. If a ring of a length less than 12 exists in the matrix, it indicates that the value j is not optional, and detection is directly performed on a next value. After all the elements in the set {1, 2, 3, ..., 127} are traversed, the process proceeds to step 3.2.3.

At step 3.2.3, whether the current optional value set Cand_$S_{2,i}$ is an empty set is determined. If Cand_$S_{2,i}$ is a non-empty set, that is, a size(Cand_$S_{2,i}$) is not equal to 0, a random number is selected from the set Cand_$S_{2,i}$ and assigned to $S_{2,i}$, the used value flag Choose_$S_{2,i}$ is set to true, i is automatically increased by 1, and then step 3.2.1 is performed for optional value search for the next element $S_{2,i+1}$. If Cand_$S_{2,i}$ is an empty set, that is, size(Cand_$S_{2,i}$)=0, it indicates that a current assigned value of the previous element $S_{2,i-1}$ affects selection of an optional value of $S_{2,i}$, it is stipulated that the search return flag Return_i is true, i is decreased by 1, and step 3.2.1 is performed.

At step 3.2.4, the used value flag Choose_$S_{2,i}$ of $S_{2,i}$ is set to false, and then whether the optional value set Cand_$S_{2,i}$ is an empty set is determined. If Cand_$S_{2,i}$ is a non-empty set, that is, the size(Cand_S2,i) is not equal to 0, a random number is selected from the set Cand_$S_{2,i}$ and assigned to the used value flag Choose_$S_{2,i}$, the used value flag Choose_$S_{2,i}$ is set to true, i is automatically increased by 1, and then step 3.2.1 is performed for optional value search for $S_{2,i+1}$. If Cand_$S_{2,i}$ is an empty set, that is, size(Cand_$S_{2,i}$)=0, whether the value of i is 1 at this time is determined. If i is equal to 1, it indicates that the cyclic shift value matrix that satisfies the conditions cannot be found under the current value of P. The current value of P is added to Step and a sum of P and Step is assigned to P again, and step 3.1 is performed to restart the search. If i is not equal to 1, it indicates that the value of the previous element $S_{2,i-2}$ affects values of $S_{2,i-1}$ and $S_{2,i}$. The search return flag Return_i is set to false, Return_(i-1) is set to true, i is decreased by 1, and step 3.2.1 is performed.

At step 3.3, when values of all elements of the third row of the matrix $H_s$ are determined, it indicates that an appropriate cyclic shift value matrix has been found, and then traversal and search is directly jumped out.

At step 4, the cyclic shift value matrix $H_s$ obtained by traversal search and the current value pf P are output. The matrix $H_s$ is as follows:

$$H_s = \begin{bmatrix} 0 & 0 & 0 & 0 & 0 & 0 & 0 & 0 & 0 & 0 & 0 & 0 \\ 0 & 10 & 15 & 39 & 40 & 42 & 51 & 59 & 73 & 77 & 120 & 127 \\ 0 & 1905 & 2447 & 2284 & 1548 & 680 & 5023 & 3440 & 2945 & 1002 & 2699 & 4629 \end{bmatrix}$$

The value of P is 5220.

At step 5, the check matrix is obtained according to the cyclic shift value matrix $H_s$ and the value of P.

Embodiment two of the present disclosure relates to a method for constructing a regular QC-LDPC code. Embodiment two is roughly the same as embodiment one, with the main differences as follows: In embodiment two of the present disclosure, a method for quickly finding a value satisfying the condition is provided.

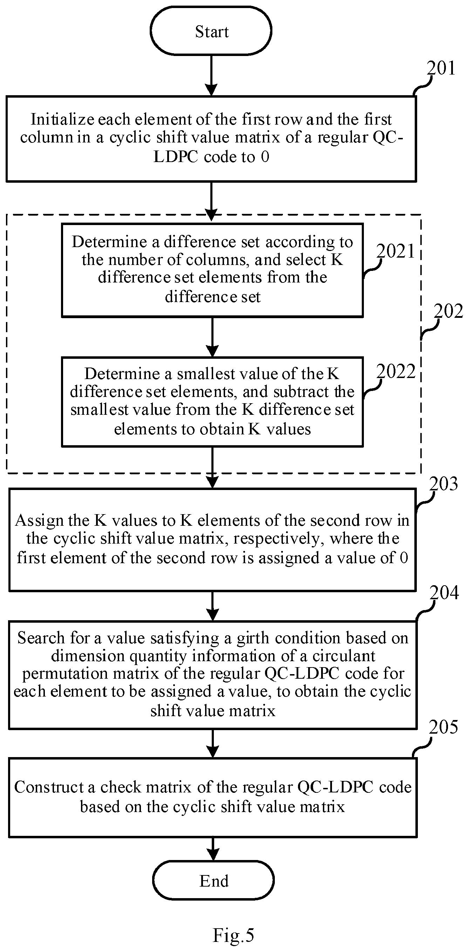

Fig. 5 is a flowchart of a method for constructing a regular QC-LDPC code according to embodiment two.

At step 201, each element of the first row and the first column in a cyclic shift value matrix of the regular QC-LDPC code is initialized to 0. Step 201 is roughly the same as step 101, and details are not described here again.

At step 202, K values satisfying a preset condition is obtained, where a value of K is equal to the number of columns of the cyclic shift value matrix, and the preset condition includes that one of the values is 0, and no duplicate number exists in a set consisting of differences each between any two of the values.

Step 202 includes the following sub-steps.

At sub-step 2021, a difference set is determined according to the number of columns, and K difference set elements are selected from the difference set.

The number of columns is K, and a difference set (v, k, λ) is obtained, where the difference set obtained according to the number of columns K includes multiple elements, and v is the largest element in this difference set. In this embodiment, it is set that k=K, and λ=1. Here, k=K indicates that K difference set elements are randomly taken from the difference set obtained according to the number of columns K. λ=1 indicates that a difference between any two difference set elements in the K taken difference set elements only occurs once. In other words, the K difference set elements satisfy the following condition: no duplicate number exists in a set consisting of differences each between any two difference set elements. For example, if the number of columns K is 8, elements {1,6,7,9,19,38,42,49} are selected from a difference set (57,8,1), where v=57.

At sub-step 2022, a smallest value of the K difference set elements is determined, and the smallest value is subtracted from the K difference set elements to obtain K values.

In order to ensure that the first element of the second row is 0, the smallest value of the K difference set elements needs to be subtracted from each of the K difference set elements, to obtain the K values, where one of the K values is 0. The K values are obtained by subtracting a same value from the K difference set elements. Therefore, the following condition is met: no duplicate number exists in a set consisting of differences each between any two numbers.

Generally, K sequential difference set elements may be taken from the difference set. In this case, the taken K difference set elements are arranged in ascending order. Therefore, the K values are arranged in ascending order, and the first value is 0. In this case, when assigning values to the elements of the second row, the K values can be assigned to the elements of the second row in the order of the K values.

At step 203, the K values are assigned to K elements of the second row in the cyclic shift value matrix, respectively, where the first element of the second row is assigned a value of 0. Step 203 is roughly the same as step 103, and details are not described here again.

At step 204, a value satisfying the girth condition is searched for based on dimension quantity information of a circulant permutation matrix of the regular QC-LDPC code for each element to be assigned a value, to obtain the cyclic shift value matrix. Each element to be assigned a value refers to an element other than elements of the first row, the second row, and the first column in the cyclic shift value matrix. Step 204 is roughly the same as step 104, and details are not described here again.

At step 205, a check matrix of the regular QC-LDPC code is constructed based on the cyclic shift value matrix. Step 205 is roughly the same as step 105, and details are not described here again.

In this embodiment, the K values satisfying the preset condition are obtained based on differences, which is efficient. Embodiment three of the present disclosure relates to a method for constructing a regular QC-LDPC code. The difference between embodiment three and embodiment two is that in embodiment three of the present disclosure, another method for quickly finding a value satisfying the condition is provided.

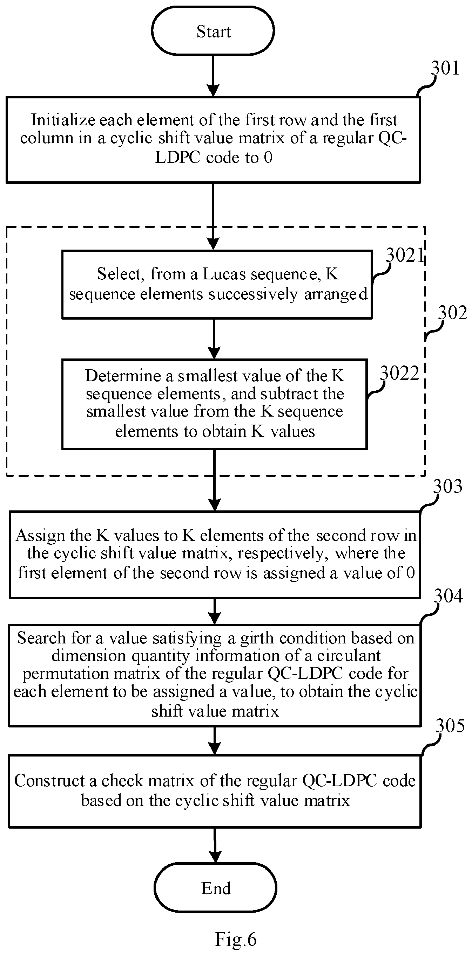

Fig. 6 is a flowchart of a method for constructing a regular QC-LDPC code according to embodiment three.

At step 301, each element of the first row and the first column in a cyclic shift value matrix of the regular QC-LDPC code is initialized to 0. Step 301 is roughly the same as step 101, and details are not described here again.

At step 302, K values satisfying a preset condition is obtained, where a value of K is equal to the number of columns of the cyclic shift value matrix, and the preset condition includes that one of the values is 0, and no duplicate number exists in a set consisting of differences each between any two of the values.

Step 302 includes the following sub-steps.

At sub-step 3021, K sequence elements successively arranged are selected from a Lucas sequence.

The Lucas sequence is a known sequence, and K sequence elements successively arranged are selected from the Lucas sequence. Due to characteristics of the Lucas sequence, the K sequence elements successively arranged satisfy the following condition: no duplicate number exists in a set consisting of differences each between any two sequences.

At sub-step 3022, a smallest value of the K sequence elements is determined, and the smallest value is subtracted from the K sequence elements to obtain K values.

In order to ensure that the first element of the second row is 0, the smallest value of the K sequence elements needs to be subtracted from each of the K sequence elements, to obtain the K values, where one of the K values is 0. Here, the K values are obtained by subtracting a same value from the K sequence elements. Therefore, the following condition is met: no duplicate number exists in a set consisting of differences each between any two numbers.

The K sequence elements successively arranged taken from the Lucas sequence are arranged in ascending order. Therefore, the K values are arranged in ascending order, and the first value is 0. In this case, when assigning values to the elements of the second row, the K values can be assigned to the elements of the second row in the order of the K values.

At step 303, the K values are assigned to K elements of the second row in the cyclic shift value matrix, respectively, where the first element of the second row is assigned a value of 0. Step 303 is roughly the same as step 103, and details are not described here again.

At step 304, a value satisfying the girth condition is searched for based on dimension quantity information of a circulant permutation matrix of the regular QC-LDPC code for each element to be assigned a value, to obtain the cyclic shift value matrix. Each element to be assigned a value refers to an element other than elements of the first row, the second row, and the first column in the cyclic shift value matrix. Step 304 is roughly the same as step 104, and details are not described here again.

At step 305, a check matrix of the regular QC-LDPC code is constructed based on the cyclic shift value matrix. Step 305 is roughly the same as step 105, and details are not described here again.

In this embodiment, the K values satisfying the preset condition are obtained based on the Lucas sequence, which is efficient.

The steps of the above methods are divided only for the sake of clear description, and during implementation, the steps may be combined into one step or one step may be split into multiple steps. All shall fall within the scope of protection of the present disclosure provided that the same logical relationship is included. Insignificant modifications added to or insignificant designs introduced into an algorithm or a procedure without changing the core of the algorithm or the procedure shall fall within the scope of protection of the present disclosure.

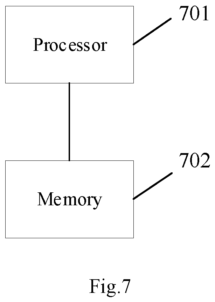

Embodiment four of the present disclosure relates to an electronic device, as shown in fig. 7, including: at least one processor 701; and a memory 702 communicatively connected with the at least one processor 701.

The memory 702 stores instructions executable by the at least one processor 701 to enable the at least one processor 701 to perform the method for constructing a regular QC-LDPC code described in any of the foregoing embodiments.

The memory 702 and the processor 701 are connected through a bus. The bus may include any number of interconnected buses and bridges. The bus connects the at least one processor 701 and various circuits of the memory 702. The bus may also connect various other circuits such as a peripheral device, a voltage regulator and a power management circuit, which are well known in the art and therefore will not be further described here. A bus interface provides an interface between the bus and a transceiver. The transceiver may be one element or multiple elements, such as multiple receivers and transmitters, and provide a unit for communicating with various other apparatuses on a transmission medium. Data that has been processed by the processor 701 is transmitted on a wireless medium by means of an antenna. Further, the antenna also receives data and transmits the data to the processor 701.

The processor 701 is responsible for bus management and general processing, and may also provide various functions, including timing, peripheral interface, voltage regulation, power management and other control functions. The memory 702 may be configured to store data used by the processor 701 when performing operations. The fifth embodiment of the present disclosure relates to a computer-readable storage medium storing a computer program. The computer program, when executed by the processor, causes the processor to perform the methods according to the embodiments above.

That is, those having ordinary skills in the art can understand that all or some of the steps in the methods for implementing the above embodiments can be completed by instructing related hardware through a program, which is stored in a storage medium and includes several instructions configured to enable a device (which may be a single-chip microcomputer, a chip, etc.) or a processor to execute all or some of the steps of the methods according to the embodiments of the present disclosure. The aforementioned storage medium includes: various media that can store program codes, such as a USB flash drive, a mobile hard disk, a read-only memory (ROM), a random-access memory (RAM), a magnetic disk or an optical disk.

Those having ordinary skills in the art can understand that the above embodiments are provided for explaining the implementations of the present disclosure, but in practical applications, various changes in form and detail can be made therein without departing from the scope of the claimed invention.

**Claims**

1. A method for constructing a regular Quasi-Cyclic Low-Density Parity-Check, QC-LDPC, code, comprising:

    initializing each element of a first row and a first column in a cyclic shift value matrix of the regular QC-LDPC code to 0 (101);
    obtaining K values satisfying a preset condition, wherein a value of K is equal to the number of columns of the cyclic shift value matrix, and the preset condition comprises that one of the K values is 0 and no duplicate number exists in a set consisting of differences each between any two of the K values (102);
    assigning the K values to K elements of a second row in the cyclic shift value matrix, respectively, wherein a first element of the second row is assigned a value of 0 (103);
    searching, based on dimension quantity information of a circulant permutation matrix of the regular QC-LDPC code, for a value satisfying a preset girth condition for each element to be assigned a value, to obtain the cyclic shift value matrix, wherein each element to be assigned a value refers to an element other than elements of the first row, the second row, and the first column in the cyclic shift value matrix (104);
    constructing a check matrix of the regular QC-LDPC code based on the cyclic shift value matrix (105); and
    using the constructed regular QC-LDPC code for error correction by processing data to be transmitted or processing received data.

2. The method for constructing a regular QC-LDPC code of claim 1, wherein obtaining K values satisfying a preset condition comprises:

    determining a difference set according to the number of columns, and selecting K difference set elements from the difference set (2021); and
determining a smallest value of the K difference set elements, and subtracting the smallest value from each of the K difference set elements to obtain the K values (2022).

3. The method for constructing a regular QC-LDPC code of claim 1, wherein obtaining K values satisfying a preset condition comprises:

selecting, from a Lucas sequence, K sequence elements successively arranged (3021); and
determining a smallest value of the K sequence elements, and subtracting the smallest value from each of the K sequence elements to obtain the K values (3022).

4. The method for constructing a regular QC-LDPC code of claim 1, wherein the girth condition comprises: a girth of the check matrix being 8, 10 or 12.

5. The method for constructing a regular QC-LDPC code of claim 1, wherein the dimension quantity information comprises an initial value and a step size of a dimension quantity; and searching, based on dimension quantity information of a circulant permutation matrix of the regular QC-LDPC code, for a value satisfying a preset girth condition for each element to be assigned a value comprises:

determining multiple candidate values according to the dimension quantity;
performing, according to the multiple candidate values, a girth detection for each element to be assigned a value, and determining whether a candidate value which makes each element to be assigned a value satisfy the girth condition exists under the dimension quantity; and
in response to existence of a candidate value that makes each element to be assigned a value satisfy the girth condition, obtaining the cyclic shift value matrix with each element assigned a value; and
in response to non-existence of a candidate value that makes each element to be assigned a value satisfy the girth condition, updating the dimension quantity according to the step size, and repeating the process of searching, based on dimension quantity information of a circulant permutation matrix of the regular QC-LDPC code, for a value satisfying a preset girth condition for each element to be assigned a value.

6. The method for constructing a regular QC-LDPC code of claim 5, wherein performing a girth detection for each element to be assigned a value according to the multiple candidate values comprises:
in response to determining, for each of the candidate values, that a respective one of the candidate values does not exist in the cyclic shift value matrix, assigning the respective one of the candidate values to the element to be assigned a value, and perform a girth detection.

7. The method for constructing a regular QC-LDPC code of claim 5, wherein performing, according to the multiple candidate values, a girth detection for each element to be assigned a value, and determining whether a candidate value that makes each element to be assigned a value satisfy the girth condition exists under the dimension quantity comprises:
for each element to be assigned a value, adding the candidate value satisfying the girth condition to an optional value set for the element to be assigned a value; and proceeding to a value assignment process, comprising:

in response to the optional value set for the element to be assigned a value being a non-empty set, selecting from the optional value set an optional value and assigning to the element to be assigned a value; and in response to each element to be assigned a value being assigned a value, determining that a candidate value that makes each element to be assigned a value satisfy the girth condition exists under the dimension quantity;
in response to the optional value set for the element to be assigned a value being an empty set and the element to be assigned a value being an element other than the first element to be assigned a value, removing a current value of a previous element to be assigned a value of the element to be assigned a value from an optional value set for the previous element to be assigned a value, and performing the value assignment process on the previous element to be assigned a value; and
in response to the optional value set for the element to be assigned a value being an empty set and the element to be assigned a value being the first element to be assigned a value, determining that no candidate value that makes each element to be assigned a value satisfy the girth condition exists under the dimension quantity, wherein the process of searching for a value satisfying the girth condition for each element to be assigned a value is performed in order from left to right and from top to bottom in the cyclic shift value matrix.

8. The method for constructing a regular QC-LDPC code of claim 5, wherein constructing a check matrix of the regular QC-LDPC code based on the cyclic shift value matrix comprises:

constructing the check matrix of the regular QC-LDPC code according to the cyclic shift value matrix and the dimension quantity, wherein a value satisfying the girth condition for each element to be assigned a value is searched for based on the dimension quantity.

9. An electronic device, comprising:

at least one processor (701); and
a memory (702) communicatively connected to the at least one processor (701);
wherein the memory (702) stores instructions executable by the at least one processor (701) to enable the at least one processor (701) to perform the method for constructing a regular QC-LDPC code of any one of claims 1 to 8.

10. A computer-readable storage medium storing a computer program which, when executed by a processor, causes the processor to perform the method for constructing a regular QC-LDPC code of any one of claims 1 to 8.

**Patentansprüche**

1. Verfahren zur Herstellung eines regulären Quasi-Cyclic Low-Density Parity-Check-Codes, QC-LDPC-Codes, umfassend:

Initialisieren jedes Elements einer ersten Zeile und einer ersten Spalte in einer Matrix mit zyklischem Verschiebungswert des regulären QC-LDPC-Codes auf 0 (101);
Erhalten von K Werten, die eine vorgegebene Bedingung erfüllen, wobei ein Wert von K gleich der Anzahl von Spalten der Matrix mit zyklischem Verschiebungswert ist und die vorgegebene Bedingung umfasst, dass einer der K Werte 0 ist und keine doppelte Zahl in einem Satz bestehend aus Differenzen zwischen jeweils beliebigen zwei der K Werte vorhanden ist (102);
Zuweisen der K Werte jeweils zu K Elementen einer zweiten Zeile in der Matrix mit zyklischem Verschiebungswert, wobei einem ersten Element der zweiten Zeile ein Wert von 0 zugewiesen wird (103);
Suchen, basierend auf Dimensionsmengeninformationen einer zirkulanten Permutationsmatrix des regulären QC-LDPC-Codes, nach einem Wert, der eine vorgegebene Umfangsbedingung für jedes Element, dem ein Wert zugewiesen werden soll, erfüllt, um die Matrix mit zyklischem Verschiebungswert zu erhalten, wobei sich jedes Element, dem ein Wert zugewiesen werden soll, auf ein anderes Element als Elemente der ersten Zeile, der zweiten Zeile und der ersten Spalte in der Matrix mit zyklischem Verschiebungswert bezieht (104);
Herstellen einer Prüfmatrix des regulären QC-LDPC-Codes basierend auf der Matrix mit zyklischem Verschiebungswert (105) und
Verwenden des hergestellten regulären QC-LDPC-Codes zur Fehlerkorrektur durch Verarbeiten von Daten, die übertragen werden sollen, oder Verarbeiten von empfangenen Daten.

2. Verfahren zur Herstellung eines regulären QC-LDPC-Codes nach Anspruch 1, wobei das Erhalten von K Werten, die eine vorgegebene Bedingung erfüllen, umfasst:

Bestimmen eines Differenzsatzes gemäß der Anzahl von Spalten und Auswählen von K Differenzsatzelementen aus dem Differenzsatz (2021) und
Bestimmen eines kleinsten Werts der K Differenzsatzelemente und Subtrahieren des kleinsten Werts von jedem der K Differenzsatzelemente, um die K Werte zu erhalten (2022).

3. Verfahren zur Herstellung eines regulären QC-LDPC-Codes nach Anspruch 1, wobei das Erhalten von K Werten, die eine vorgegebene Bedingung erfüllen, umfasst:

Auswählen, aus einer Lucas-Folge, von K Folgeelementen, die nacheinander angeordnet sind (3021); und
Bestimmen eines kleinsten Werts der K Folgeelemente und Subtrahieren des kleinsten Werts von jedem der K Folgeelemente, um die K Werte zu erhalten (3022).

**4.** Verfahren zur Herstellung eines regulären QC-LDPC-Codes nach Anspruch 1, wobei die Umfangsbedingung umfasst: ein Umfang der Prüfmatrix ist 8, 10 oder 12.

**5.** Verfahren zur Herstellung eines regulären QC-LDPC-Codes nach Anspruch 1, wobei die Dimensionsmengeninformationen einen Anfangswert und eine Schrittgröße einer Dimensionsmenge umfassen und das Suchen, basierend auf Dimensionsmengeninformationen einer zirkulanten Permutationsmatrix des regulären QC-LDPC-Codes, nach einem Wert, der eine vorgegebene Umfangsbedingung für jedes Element, dem ein Wert zugewiesen werden soll, erfüllt, umfasst:

Bestimmen von mehreren möglichen Werten gemäß der Dimensionsmenge;
Durchführen, gemäß den mehreren möglichen Werten, einer Umfangserkennung für jedes Element, dem ein Wert zugewiesen werden soll, und Bestimmen, ob ein möglicher Wert, der jedes Element, dem ein Wert, der die Umfangsbedingung erfüllt, zugewiesen werden soll, ergibt, unter der Dimensionsmenge vorhanden ist; und
als Reaktion auf das Vorhandensein eines möglichen Werts, der jedes Element, dem ein Wert, der die Umfangsbedingung erfüllt, zugewiesen werden soll, ergibt, Erhalten der Matrix mit zyklischem Verschiebungswert mit jedem Element, dem ein Wert zugewiesen ist; und
als Reaktion auf das Nichtvorhandensein eines möglichen Werts, der jedes Element, dem ein Wert, der die Umfangsbedingung erfüllt, zugewiesen werden soll, ergibt, Aktualisieren der Dimensionsmenge gemäß der Schrittgröße und Wiederholen des Prozesses zum Suchen, basierend auf Dimensionsmengeninformationen einer zirkulanten Permutationsmatrix des regulären QC-LDPC-Codes, nach einem Wert, der eine vorgegebene Umfangsbedingung für jedes Element, dem ein Wert zugewiesen werden soll, erfüllt.

**6.** Verfahren zur Herstellung eines regulären QC-LDPC-Codes nach Anspruch 5, wobei das Durchführen einer Umfangserkennung für jedes Element, dem ein Wert zugewiesen werden soll, gemäß den mehreren möglichen Werten umfasst:
als Reaktion auf das Bestimmen, für jeden der möglichen Werte, dass ein jeweiliger der möglichen Werte in der Matrix mit zyklischem Verschiebungswert nicht vorhanden ist, Zuweisen des jeweiligen der möglichen Werte zum Element, dem ein Wert zugewiesen werden soll, und Durchführen einer Umfangserkennung.

**7.** Verfahren zur Herstellung eines regulären QC-LDPC-Codes nach Anspruch 5, wobei das Durchführen, gemäß den mehreren möglichen Werten, einer Umfangserkennung für jedes Element, dem ein Wert zugewiesen werden soll, und Bestimmen, ob ein möglicher Wert, der jedes Element, dem ein Wert, der die Umfangsbedingung erfüllt, zugewiesen werden soll, ergibt, unter der Dimensionsmenge vorhanden ist, umfasst:
für jedes Element, dem ein Wert zugewiesen werden soll, Hinzufügen des möglichen Werts, der die Umfangsbedingung erfüllt, zu einem optionalen Wertesatz für das Element, dem ein Wert zugewiesen werden soll; und Fortfahren zu einem Wertzuweisungsprozess, umfassend:

als Reaktion darauf, dass der optionale Wertesatz für das Element, dem ein Wert zugewiesen werden soll, ein nicht leerer Satz ist, Auswählen aus dem optionalen Wertesatz eines optionalen Werts und Zuweisen zum Element, dem ein Wert zugewiesen werden soll; und als Reaktion darauf, dass jedem Element, dem ein Wert zugewiesen werden soll, ein Wert zugewiesen ist, Bestimmen, dass ein möglicher Wert, der jedes Element, dem ein Wert, der die Umfangsbedingung erfüllt, zugewiesen werden soll, ergibt, unter der Dimensionsmenge vorhanden ist;
als Reaktion darauf, dass der optionale Wertesatz für das Element, dem ein Wert zugewiesen werden soll, ein leerer Satz ist und das Element, dem ein Wert zugewiesen werden soll, ein anderes Element als das erste Element, dem ein Wert zugewiesen werden soll, ist, Entfernen eines aktuellen Werts eines vorhergehenden Elements, dem ein Wert zugewiesen werden soll, des Elements, dem ein Wert zugewiesen werden soll, aus einem optionalen Wertesatz für das vorhergehende Element, dem ein Wert zugewiesen werden soll, und Durchführen des Wertzuweisungsprozesses am vorhergehenden Element, dem ein Wert zugewiesen werden soll; und
als Reaktion darauf, dass der optionale Wertesatz für das Element, dem ein Wert zugewiesen werden soll, ein leerer Satz ist und das Element, dem ein Wert zugewiesen werden soll, das erste Element, dem ein Wert zugewiesen werden soll, ist, Bestimmen, dass kein möglicher Wert, der jedes Element, dem ein Wert, der die Umfangsbedingung erfüllt, zugewiesen werden soll, ergibt, unter der Dimensionsmenge vorhanden ist,
wobei der Prozess zum Suchen nach einem Wert, der die Umfangsbedingung erfüllt, für jedes Element, dem ein Wert zugewiesen werden soll, in einer Reihenfolge von links nach rechts und von oben nach unten in der Matrix mit zyklischem Verschiebungswert durchgeführt wird.

**8.** Verfahren zur Herstellung eines regulären QC-LDPC-Codes nach Anspruch 5, wobei das Herstellen einer Prüfmatrix des regulären QC-LDPC-Codes basierend auf der Matrix mit zyklischem Verschiebungswert umfasst:
Herstellen der Prüfmatrix des regulären QC-LDPC-Codes gemäß der Matrix mit zyklischem Verschiebungswert und der Dimensionsmenge, wobei nach einem Wert, der die Umfangsbedingung erfüllt, für jedes Element, dem ein Wert zugewiesen werden soll, basierend auf der Dimensionsmenge gesucht wird.

9. Elektronische Vorrichtung, umfassend:

mindestens einen Prozessor (701) und
einen Speicher (702), der kommunikativ mit dem mindestens einen Prozessor (701) verbunden ist; wobei der Speicher (702) Anweisungen speichert, die durch den mindestens einen Prozessor (701) ausführbar sind, um es dem mindestens einen Prozessor (701) zu ermöglichen, das Verfahren zur Herstellung eines regulären QC-LDPC-Codes nach einem der Ansprüche 1 bis 8 durchzuführen.

10. Computerlesbares Speichermedium, das ein Computerprogramm speichert, das bei Ausführung durch einen Prozessor den Prozessor dazu veranlasst, das Verfahren zur Herstellung eines regulären QC-LDPC-Codes nach einem der Ansprüche 1 bis 8 durchzuführen.

**Revendications**

1. Procédé pour construire un code de contrôle de parité quasi-cyclique à faible densité, QC-LDPC, classique, comprenant :

l'initialisation de chaque élément d'une première rangée et d'une première colonne dans une matrice de valeurs de décalage cyclique du code QC-LDPC classique à 0 (101) ;
l'obtention de K valeurs satisfaisant une condition prédéfinie, dans lequel une valeur de K est égale au nombre de colonnes de la matrice de valeurs de décalage cyclique, et la condition prédéfinie comprend que l'une des K valeurs soit 0 et qu'aucun nombre en double n'existe dans un ensemble constitué des différences entre chaque deux quelconques des K valeurs (102) ;
l'attribution des K valeurs à K éléments d'une deuxième rangée dans la matrice de valeurs de décalage cyclique, respectivement, dans lequel un premier élément de la deuxième rangée se voit attribuer une valeur de 0 (103) ;
la recherche, sur la base des informations de quantité dimensionnelles d'une matrice de permutation circulante du code QC-LDPC classique, d'une valeur satisfaisant une condition de circonférence prédéfinie pour chaque élément auquel une valeur doit être attribuée, pour obtenir la matrice de valeurs de décalage cyclique, dans lequel chaque élément auquel une valeur doit être attribuée fait référence à un élément autre que les éléments de la première rangée, de la deuxième rangée et de la première colonne dans la matrice de valeurs de décalage cyclique (104) ;
la construction d'une matrice de contrôle du code QC-LDPC classique sur la base de la matrice de valeurs de décalage cyclique (105) ; et
l'utilisation du code QC-LDPC classique construit pour la correction d'erreurs en traitant les données à transmettre ou en traitant les données reçues.

2. Procédé de construction d'un code QC-LDPC classique selon la revendication 1, dans lequel l'obtention de K valeurs satisfaisant une condition prédéfinie comprend :

la détermination d'un ensemble de différences en fonction du nombre de colonnes, et la sélection de K éléments d'ensemble de différences dans l'ensemble de différences (2021) ; et
la détermination d'une plus petite valeur des K éléments de l'ensemble de différences, et la soustraction de la plus petite valeur de chacun des K éléments d'ensemble de différences pour obtenir les K valeurs (2022).

3. Procédé de construction d'un code QC-LDPC classique selon la revendication 1, dans lequel l'obtention de K valeurs satisfaisant une condition prédéfinie comprend :

la sélection, à partir d'une séquence Lucas, de K éléments de séquence disposés successivement (3021) ; et
la détermination d'une plus petite valeur des K éléments de séquence, et la soustraction de la plus petite valeur de chacun des K éléments de séquence pour obtenir les K valeurs (3022).

4. Procédé de construction d'un code QC-LDPC classique selon la revendication 1, dans lequel la condition de circonférence comprend : une circonférence de la matrice de contrôle étant 8, 10 ou 12.

5. Procédé de construction d'un code QC-LDPC classique selon la revendication 1, dans lequel les informations de quantité dimensionnelle comprennent une valeur initiale et une taille de pas d'une quantité dimensionnelle ; et la recherche, sur la base d'informations de quantité dimensionnelle d'une matrice de permutation circulante du code QC-LDPC classique, d'une valeur satisfaisant une condition de circonférence prédéfinie pour chaque élément auquel une valeur doit être attribuée comprend :

la détermination de multiples valeurs candidates en fonction de la quantité dimensionnelle ;
l'exécution, en fonction des multiples valeurs candidates, d'une détection de circonférence pour chaque élément auquel une valeur doit être attribuée, et la détermination si une valeur candidate qui fait que chaque élément auquel une valeur doit être attribuée satisfait la condition de circonférence existe sous la quantité dimensionnelle ; et
en réponse à l'existence d'une valeur candidate qui fait que chaque élément auquel une valeur doit être attribuée satisfait la condition de circonférence, l'obtention de la matrice de valeurs de décalage cyclique avec chaque élément auquel une valeur est affectée ; et
en réponse à l'inexistence d'une valeur candidate qui fait que chaque élément auquel une valeur doit être attribuée satisfait la condition de circonférence, l'actualisation de la quantité dimensionnelle en fonction de la taille du pas, et la répétition du processus de recherche, sur la base d'informations de quantité dimensionnelle d'une matrice à permutation circulante du code QC-LDPC classique, pour une valeur satisfaisant une condition de circonférence prédéfinie pour chaque élément auquel une valeur doit être attribuée.

6. Procédé de construction d'un code QC-LDPC classique selon la revendication 5, dans lequel l'exécution d'une détection de circonférence pour chaque élément auquel une valeur doit être attribuée en fonction des multiples valeurs candidates comprend :

en réponse à la détermination, pour chacune des valeurs candidates, qu'aucune respective parmi les valeurs candidates n'existe dans la matrice de valeurs de décalage cyclique, l'attribution de l'une respective parmi les valeurs candidates à l'élément auquel une valeur doit être attribuée, et l'exécution d'une détection de circonférence.

7. Procédé de construction d'un code QC-LDPC classique selon la revendication 5, dans lequel l'exécution, en fonction des multiples valeurs candidates, d'une détection de circonférence pour chaque élément auquel une valeur doit être attribuée, et la détermination si une valeur candidate qui fait que chaque élément se voit attribuer une valeur satisfait la condition de circonférence existe sous la quantité dimensionnelle comprend :
pour chaque élément auquel une valeur doit être attribuée, l'ajout de la valeur candidate satisfaisant la condition de circonférence à un ensemble de valeurs facultatives pour l'élément auquel une valeur doit être attribuée ; et la poursuite d'un processus d'attribution de valeur, comprenant :

en réponse au fait que l'ensemble de valeurs facultatives pour l'élément auquel une valeur doit être attribuée soit un ensemble non vide, la sélection parmi l'ensemble de valeurs facultatives d'une valeur facultative et l'attribution à l'élément auquel une valeur doit être attribuée d'une valeur ; et en réponse au fait qu'à chaque élément auquel une valeur doit être attribuée se voit attribuer une valeur, la détermination qu'une valeur candidate qui fait que chaque élément auquel une valeur doit être attribuée satisfait la condition de circonférence existe sous la quantité dimensionnelle ;
en réponse au fait que l'ensemble de valeurs facultatives pour l'élément auquel une valeur doit être attribuée soit un ensemble vide et que l'élément auquel une valeur doit être attribuée soit un élément autre que le premier élément auquel une valeur doit être attribuée, la suppression d'une valeur actuelle d'un élément précédent auquel une valeur doit être attribuée de l'élément auquel une valeur doit être attribuée à partir d'un ensemble de valeurs facultatives pour l'élément précédent auquel une valeur doit être attribuée, et l'exécution du processus d'attribution de valeur sur l'élément précédent auquel une valeur doit être attribuée ; et
en réponse au fait que l'ensemble de valeurs facultatives pour l'élément auquel une valeur doit être attribuée soit un ensemble vide et que l'élément auquel une valeur doit être attribuée soit le premier élément auquel une valeur doit être attribuée, la détermination qu'aucune valeur candidate qui fait de chaque élément auquel une valeur doit être attribuée satisfait la condition de circonférence n'existe sous la quantité dimensionnelle,
dans lequel le processus de recherche d'une valeur satisfaisant la condition de circonférence pour chaque élément auquel une valeur doit être attribuée est effectué dans l'ordre de gauche à droite et de haut en bas dans la matrice de valeurs de décalage cyclique.

8. Procédé de construction d'un code QC-LDPC classique selon la revendication 5, dans lequel la construction d'une matrice de contrôle du code QC-LDPC classique sur la base de la matrice de valeurs de décalage cyclique comprend :
la construction de la matrice de contrôle du code QC-LDPC classique en fonction de la matrice de valeurs de décalage cyclique et de la quantité dimensionnelle, dans lequel une valeur satisfaisant la condition de circonférence pour chaque élément auquel une valeur doit être attribuée est recherchée sur la base de la quantité dimensionnelle.

9. Dispositif électronique, comprenant :

au moins un processeur (701) ; et
une mémoire (702) connectée fonctionnellement à l'au moins un processeur (701),
dans lequel la mémoire (702) stocke des instructions exécutables par l'au moins un processeur (701) pour permettre à l'au moins un processeur (701) d'exécuter le procédé de construction d'un code QC-LDPC classique selon l'une quelconque des revendications 1 à 8.

10. Support de stockage lisible par ordinateur stockant un programme informatique qui, lorsqu'il est exécuté par un processeur, amène le processeur à exécuter le procédé de construction d'un code QC-LDPC classique selon l'une quelconque des revendications 1 à 8.

$$H = \begin{bmatrix} I(s_{0,0}) & I(s_{0,1}) & \cdots & I(s_{0,K-1}) \\ I(s_{1,0}) & I(s_{1,1}) & \cdots & I(s_{1,K-1}) \\ \vdots & \vdots & \ddots & \vdots \\ I(s_{J-1,0}) & I(s_{J-1,1}) & \cdots & I(s_{J-1,K-1}) \end{bmatrix}$$

Fig.1

$$H_s = \begin{bmatrix} s_{0,0} & s_{0,1} & \cdots & s_{0,K-1} \\ s_{1,0} & s_{1,1} & \cdots & s_{1,K-1} \\ \vdots & \vdots & \ddots & \vdots \\ s_{J-1,0} & s_{J-1,1} & \cdots & s_{J-1,K-1} \end{bmatrix}$$

Fig.2

Start

Initialize each element of the first row and the first column in a cyclic shift value matrix of a regular QC-LDPC code to 0 —101

Obtain K values satisfying a preset condition, where the preset condition includes that one of the values is 0, and no duplicate number exists in a set consisting of differences each between any two of the values —102

Assign the K values to K elements of the second row in the cyclic shift value matrix, respectively, where the first element of the second row is assigned a value of 0 —103

Search for a value satisfying a girth condition based on dimension quantity information of a circulant permutation matrix of the regular QC-LDPC code for each element to be assigned a value, to obtain the cyclic shift value matrix —104

Construct a check matrix of the regular QC-LDPC code based on the cyclic shift value matrix —105

End

Fig.3

104

Determine multiple candidate
values according to a dimension
quantity
1041

Perform, according to the multiple
candidate values, a girth detection for each element to be
assigned a value, and determining whether an candidate value
that makes each element to be assigned a value satisfy the girth
condition exists under the dimension quantity
1042

Yes

No     1044

1043

Obtain a cyclic shift value
matrix with each element
assigned a value

Update the dimension quantity
by using a step size

Proceed to step 105

Fig.4

Start

201

Initialize each element of the first row and the first column in a cyclic shift value matrix of a regular QC-LDPC code to 0

2021

Determine a difference set according to the number of columns, and select K difference set elements from the difference set

202

2022

Determine a smallest value of the K difference set elements, and subtract the smallest value from the K difference set elements to obtain K values

203

Assign the K values to K elements of the second row in the cyclic shift value matrix, respectively, where the first element of the second row is assigned a value of 0

204

Search for a value satisfying a girth condition based on dimension quantity information of a circulant permutation matrix of the regular QC-LDPC code for each element to be assigned a value, to obtain the cyclic shift value matrix

205

Construct a check matrix of the regular QC-LDPC code based on the cyclic shift value matrix

End

Fig.5

Start

Initialize each element of the first row and the first column in a cyclic shift value matrix of a regular QC-LDPC code to 0

301

Select, from a Lucas sequence, K sequence elements successively arranged

3021

302

Determine a smallest value of the K sequence elements, and subtract the smallest value from the K sequence elements to obtain K values

3022

Assign the K values to K elements of the second row in the cyclic shift value matrix, respectively, where the first element of the second row is assigned a value of 0

303

Search for a value satisfying a girth condition based on dimension quantity information of a circulant permutation matrix of the regular QC-LDPC code for each element to be assigned a value, to obtain the cyclic shift value matrix

304

Construct a check matrix of the regular QC-LDPC code based on the cyclic shift value matrix

305

End

Fig.6

Fig.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Efficient Search of Compact QC-LDPC and SC-LDPC Convolutional Codes with Large Girth. **MOHAMMAD H TADAYON et al.** ARXIV.ORG. CORNELL UNIVERSITY LIBRARY, 201 OLIN LIBRARY CORNELL UNIVERSITY ITHACA, 17 April 2018
- Constructions of QC LDPC codes based on integer sequences. **ZHANG LIJUN et al.** SCIENCE CHINA INFORMATION SCIENCES. SCIENCE CHINA PRESS, 13 May 2014, vol. 57
- Next Generation FEC for High-Capacity Communication in Optical Transport Networks. **IVAN B DJORDJEVIC et al.** JOURNAL OF LIGHTWAVE TECHNOLOGY. IEEE, 15 August 2009, vol. PP, 3518-3530
- Compact QC-LDPC Block and SC-LDPC Convolutional Codes for Low-Latency Communications. **BATTAGLIONI MASSIMO et al.** PROC., IEEE 29TH ANNUAL INTERNATIONAL SYMPOSIUM ON PERSONAL. INDOOR AND MOBILE RADIO COMMUNICATIONS (PIMRC), 09 September 2018
- **TASDIGHI ALIREZA et al.** Symmetrical Constructions for Regular Girth-8 QC-LDPC Codes. *IEEE TRANSACTIONS ON COMMUNICATIONS, PISCATAWAY, NJ. USA,* 13 October 2016, vol. 65